Europäisches Patentamt

European Patent Office

Office européen des brevets

(19)

(11) Numéro de publication : **0 098 203**
**B1**

(12) # FASCICULE DE BREVET EUROPÉEN

(45) Date de publication du fascicule du brevet :
01.10.86

(51) Int. Cl.⁴ : **H 03 K 3/037**, H 03 K 3/356,
H 03 K 23/60

(21) Numéro de dépôt : 83401265.0

(22) Date de dépôt : 17.06.83

(54) Bascule logique, fonctionnant du continu à 10 GHz, et diviseur de fréquence comportant cette bascule.

(30) Priorité : 29.06.82 FR 8211403

(43) Date de publication de la demande :
11.01.84 Bulletin 84/02

(45) Mention de la délivrance du brevet :
01.10.86 Bulletin 86/40

(84) Etats contractants désignés :
DE GB IT NL

(56) Documents cités :
FR-A- 2 362 534
US-A- 3 845 325
IEEE INTERNATIONAL SOLID STATE CIRCUITS
CONFERENCE, vol. 20, no. 20, 18 février 1977, pages
198-199, IEEE, New York, USA. R. VAN TUYL et al.: "4-
GHz frequency division with GaAs MESFETICs"
ELECTRONICS LETTERS, vol. 16, no. 14, 3 juillet 1980,
pages 535-536, Hitchin, Herts., GB. M. CHATHELIN et
al.: "5 GHz binary frequency division on GaAs"

(73) Titulaire : THOMSON-CSF
173, Boulevard Haussmann
F-75379 Paris Cedex 08 (FR)

(72) Inventeur : Gloanec, Maurice
THOMSON-CSF SCPI 173, bld Haussmann
F-75379 Paris Cedex 08 (FR)
Inventeur : Bert, Georges
THOMSON-CSF SCPI 173, bld Haussmann
F-75379 Paris Cedex 08 (FR)
Inventeur : Perea, Ernesto
THOMSON-CSF SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

**Description**

La présente invention concerne une bascule logique très rapide, dont la structure a été étudiée en vue de simplifier l'organisation interne de la bascule et d'améliorer ses performances, notamment dans les très hautes fréquences entre 5 et 10 GHz. Elle concerne également l'application de cette bascule logique à un diviseur de fréquences par 2, fonctionnant du courant continu à 10 GHz en fréquence, ce diviseur de fréquences étant réalisé notamment sous la forme de circuit intégré sur arséniure de gallium. Le développement de la microélectronique hyperfréquence, c'est-à-dire celle qui est réalisée sur des matériaux nouveaux du type de l'arséniure de gallium et d'autres dérivés des matériaux des familles III-V et II-VI, a nécessité le développement parallèle de moyens de contrôle et de traitement des signaux hyperfréquences. En effet, à un système hyperfréquence sont généralement associés des moyens ou des organes de contrôle et de traitement, sous forme de circuits intégrés travaillant à des fréquences maximales de l'ordre de quelques centaines de MHz. Par exemple, à un dispositif hyperfréquence sur arséniure de gallium sont souvent associés des circuits sur silicium dans la technologie dite ECL. Il est donc nécessaire d'interfacer la partie du système qui travaille en hyperfréquence, générée par des circuits sur arséniure de gallium, et la partie du système qui travaille avec des circuits réalisés sur silicium, et par conséquent de faire une division de fréquences pour descendre des GHz aux MHz.

Sans mettre en cause la méthode de la transposition de fréquences, selon laquelle une fréquence donnée est mesurée par rapport à des fréquences locales générées par des oscillateurs locaux de très grandes stabilités, les solutions techniques s'orientent actuellement vers la division de fréquences, qui s'avère être très intéressante, à condition que les circuits diviseurs :

— fonctionnent à de très hautes fréquences, d'au moins 1 GHz, c'est-à-dire au moins deux fois la fréquence des techniques les plus performantes actuellement,

— travaillent dans une bande de fréquences élevées, de façon à ce qu'il ne soit plus utile de recourir à des oscillateurs locaux de références,

— si leur fréquence de sortie est compatible avec celle des circuits intégrés traditionnels, c'est-à-dire si le rang de division est suffisamment important. Le passage d'une fréquence en GHz à une fréquence en MHz est obtenu par une suite de diviseurs, en nombre suffisant.

Dans le domaine de la division de fréquence périodique, des résultats très intéressants ont été obtenus dans la bande 5 à 15 GHz, au moyen de structures utilisant des diodes Gunn planar. Cependant, ces diviseurs de fréquences périodiques ont l'inconvénient d'avoir une largeur de bande de fonctionnement relativement étroite, puisque Δf/f = 10 %. Les diviseurs de fréquences apériodiques les plus performants travaillent dans une bande de fréquences plus large, mais ils nécessitent l'application de deux signaux complémentaires, ce qui n'est pas un inconvénient car le signal complémentaire est facile à générer.

Par ailleurs, les cellules de base des bascules maître-esclave, qui sont elles-mêmes à la base des diviseurs de fréquence, sont actuellement assez bien connues, et leur configuration stabilisée. Par exemple, un article intitulé « 4 GHz frequency Division with GaAs Mesfet ICs », publié dans IEEE International Solid-State Circuits Conference, vol. 20, N° 20, pages 198-199, donne le schéma d'une cellule qui comporte un étage d'entrée constitué par quatre opérateurs logiques OU-NON et un second étage constitué par deux opérateurs logiques OU. Les signaux d'entrée sont adressés sur une entrée des premier et quatrième opérateurs OU-NON, qui reçoivent sur leur autre entrée un signal d'horloge. Un signal complémentaire d'horloge est adressé sur une entrée des second et troisième opérateurs OU-NON, qui reçoivent sur leur autre entrée le signal de sortie d'un opérateur OU, rebouclé en croix. Ce type de bascule permet de diviser la fréquence d'entrée jusqu'à 4 GHz.

Les diviseurs de fréquences actuellement connus travaillent jusqu'à des fréquences de 5,5 GHz : il est donc nécessaire d'opérer une progression d'ordre 2 au moins pour qu'une nouvelle structure présente de l'intérêt. C'est ce résultat qui est couvert par le diviseur de fréquences selon l'invention.

Le diviseur de fréquences selon l'invention, c'est-à-dire également la bascule qui est à la base de la réalisation d'un diviseur, a été étudié avec un double objectif. D'une part, son schéma électrique a été optimisé de façon à le simplifier, par diminution du nombre d'étages, donc une diminution des temps de propagation à travers les étages et par voie de conséquence une augmentation de la fréquence maximum de fonctionnement. Par ailleurs, il est nécessaire que le schéma logique retenu soit compatible avec les techniques les plus avancées, notamment en ce qui concerne le dimensionnement des composants et leur réalisation sur des matériaux rapides de la famille de l'arséniure de gallium et des composés III-V. En effet, lorsque les fréquences de fonctionnement d'un dispositif microélectronique se comptent en GHz, le dimensionnement des composants, c'est-à-dire par exemple la longueur de grille d'un transistor à effet de champ prend une importance qui n'est pas négligeable puisque dans certains cas on ne sait pas réaliser des grilles suffisamment fines, en raison des limites apportées par les techniques de masquage, bien que cet exemple ne soit cité que pour montrer l'importance entre la compatibilité d'un schéma électrique et sa réalisation.

Les performances de la bascule sont dues à sa structure qui groupe des opérateurs logiques de type OU-NON/OU, l'association de ces deux types d'opérateurs permettant des simplifications dans le schéma. Ces simplifications sont rendues possibles par des redondances entre opérateurs, lesquelles ont permis de ne plus avoir que trois étages d'opérateurs au lieu de quatre entre l'entrée et la sortie de la bascule.

De façon plus précise, l'invention concerne une bascule logique fonctionnant du continu à 10 GHz, comportant un premier étage (étage d'entrée) constitué par quatre opérateurs logiques OU-NON en parallèle, et un second étage (étage intermédiaire) constitué par deux opérateurs logiques OU en parallèle, le premier étage comportant deux entrées sur lesquelles sont adressés deux signaux complémentaires à fréquence $f_e$, l'une des deux entrées étant reliée à une entrée de chacun des premier et quatrième opérateurs logiques OU-NON, tandis que l'autre entrée est reliée à une entrée de chacun des deuxième et troisième opérateurs logiques OU-NON,

— le signal de sortie du premier opérateur OU du second étage, qui reçoit sur ses entrées les signaux du premier et du second opérateurs OU-NON du premier étage, est rebouclé sur une entrée du troisième opérateur OU-NON du premier étage,

— le signal de sortie du second opérateur OU du second étage, qui reçoit sur ses entrées les signaux du troisième et du quatrième opérateur OU-NON du premier étage, est rebouclé sur une entrée du second opérateur OU-NON du premier étage,

— cette bascule logique étant caractérisée en ce qu'elle comprend en outre un troisième étage (étage de sortie) constitué par deux opérateurs logiques OU en parallèle,

— le signal de sortie de chacun des quatre opérateurs du premier étage est adressé en parallèle à un opérateur OU du second étage et à un opérateur OU du troisième étage,

— le signal de sortie du premier opérateur OU du troisième étage, qui reçoit sur ses entrées les signaux du premier et du troisième opérateurs OU-NON du premier étage, est rebouclé sur une entrée du quatrième opérateur OU-NON du premier étage,

— le signal de sortie du second opérateur OU du troisième étage, qui reçoit sur ses entrées les signaux du second et du quatrième opérateur OU-NON du premier étage, est rebouclé sur une entrée du premier opérateur OU-NON du premier étage.

L'invention sera mieux comprise par la description de la bascule rapide qui s'appuie sur les figures jointes en annexe, lesquelles représentent :

figure 1  schéma logique simplifié d'une bascule de type RST maître-esclave selon l'art connu,

figure 2  schéma logique d'une bascule de type RST$\overline{\text{T}}$ maître esclave,

figure 3  schéma logique d'un opérateur complexe bascule de type ET/OU-NON,

figure 4  schéma électrique de l'opérateur complexe précédent,

figure 5  schéma logique d'un opérateur complexe OU-NON/OU

figure 6  schéma logique d'un diviseur par 2 regroupant deux bascules de type RST$\overline{\text{T}}$ conçue à partir d'opérateurs complexes OU-NON/OU,

figure 7  schéma électrique d'un opérateur complexe OU-NON/OU,

figure 8  schéma logique d'un diviseur par 2 selon l'invention,

figure 9  schéma électrique d'un diviseur par 2 selon l'invention.

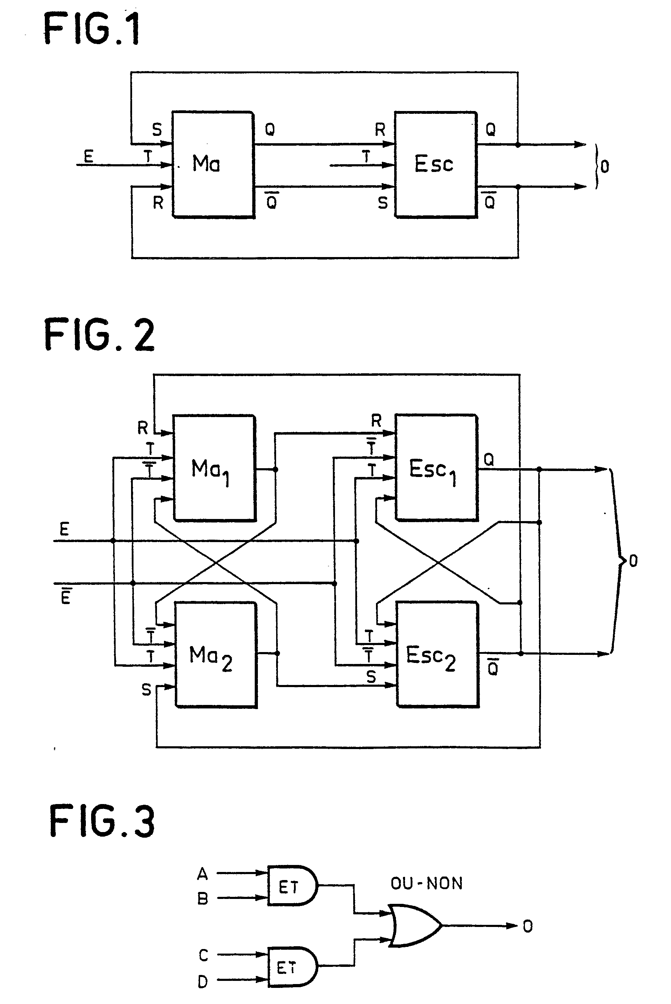

Pour diviser des fréquences dans des gammes de 5 à 10 GHz, il est évident qu'il faut avoir recours aux techniques les plus avancées et que ces diviseurs de fréquences sont réalisés avec des transistors à effet de champ performants et le plus souvent selon une technologie dite logique à transistors à effet de champ interfacée (BFL). Les diviseurs de fréquences apériodiques les plus performants sont obtenus par rebouclage d'une bascule maître-esclave dite RS représentée en figure 1.

Pour représenter cette bascule rebouclée, on conserve les symboles internationaux et cette bascule est composée de deux bascules élémentaires RST. La bascule élémentaire maître, repérée Ma, reçoit sur son entrée un signal T et il délivre sur ses deux sorties complémentaires Q et $\overline{\text{Q}}$ des signaux appliqués sur les deux entrées R et S de la bascule élémentaire esclave repérée Esc. Les deux sorties Q et $\overline{\text{Q}}$ de l'opérateur esclave sont en partie rebouclées sur les deux entrées R et S de l'opérateur élémentaire maître Ma. L'entrée R correspond à la remise à zéro (RESET en anglais) et entrée S correspond à la remise à 1 (SET en anglais). Les sorties Q et $\overline{\text{Q}}$ sont dites complémentaires. Si un signal à une fréquence $f_e$ est appliqué à l'entrée E sur la borne T de l'opérateur maître, un signal de fréquence $f_e/2$ est disponible à la sortie des opérateurs.

En fait, la figure 1 est un schéma logique simplifié et chaque opérateur comporte deux étages, chaque étage ayant un temps de transition $t_{pd}$, ce qui fait que le temps de transition pour l'opérateur maître est de $2t_{pd}$, le temps de transition pour l'opérateur esclave est de $2t_{pd}$ et la fréquence maximale de fonctionnement d'une bascule RST est $1/4t_{pd}$ si l'on admet que les temps de propagation dans l'opérateur maître et dans l'opérateur esclave sont les mêmes.

Un perfectionnement qui permet de doubler la fréquence maximale d'un diviseur, outre le fait que l'opérateur maître et l'opérateur esclave sont identiques, consiste à utiliser un verrouillage horlogé des portes, c'est-à-dire à avoir une bascule de type RST$\overline{\text{T}}$, dans laquelle $\overline{\text{T}}$ est le signal complémentaire du signal d'entrée T. En raison du rebouclage, le temps de transition n'est plus que $1t_{pd}$ pour l'opérateur maître et $1t_{pd}$ pour l'opérateur esclave, et la fréquence maximale de fonctionnement $1/2t_{pd}$. La figure 2 représente une telle bascule rebouclée et à verrouillage horlogé des portes.

Sans entrer dans le détail d'une telle bascule qui fait partie de l'art connu, on voit qu'elle est constituée de quatre opérateurs complexes, deux opérateurs complexes maîtres $Ma_1$ et $Ma_2$ à gauche de la figure et deux opérateurs complexes $Esc_1$ et $Esc_2$ à droite de la figure. Les signaux de sortie des opérateurs sont rebouclés. Dans ce cas, les signaux d'entrée, sur les deux entrées E et $\bar{E}$ doivent nécessairement être complémentaires.

C'est ce genre de bascule qui est utilisée le plus fréquemment pour les diviseurs de fréquences les plus performants actuellement réalisés et l'architecture retenue, dans l'art connu, est représentée en figure 3.

Il s'agit d'un opérateur ET/OU-NON comportant deux opérateurs ET dont les entrées reçoivent les signaux, désignés sur ce schéma logique général par les appellations ABC et D, et dont les sorties sont appliquées à un opérateur élémentaire OU-NON. En fait la réalisation de cette fonction, tout à fait valable pour des fréquences moyennement élevées, c'est-à-dire jusque 4 à 5 GHz, s'oppose à ce qu'un tel opérateur puisse fonctionner à des fréquences plus élevées.

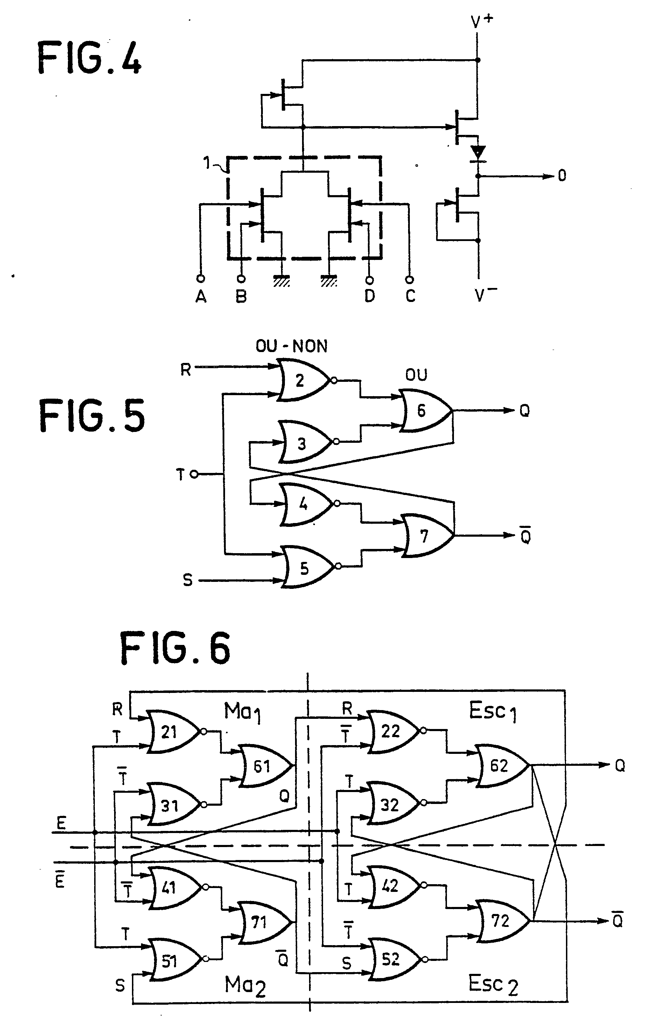

En effet, la fonction logique $0 = \overline{A.B + C.D}$ est réalisée par l'intégration sur une pastille de matériau rapide de transistors mono-grille, bi-grilles, et de diodes de décalage, comme le montre la figure 4.

La figure 4 est un schéma électrique de l'opérateur ET/OU-NON de la figure précédente. C'est l'ensemble des deux opérateurs ET de la bascule qui limite la vitesse de fonctionnement de ce dispositif. Ces deux opérateurs qui sur la figure 4 sont entourés par un rectangle pointillé repéré 1 sont constitués chacun en ce qui le concerne, par un transistor à effet de champ à deux grilles, chaque grille constituant l'une des deux entrées d'une porte ET. Or, d'une part le diviseur de fréquences étudié doit travailler à de très hautes fréquences telles que 10 GHz, ce qui entraîne que les transistors sont de dimensions extrêmement petites et leurs grilles de dimensions encore plus petites et atteignent donc les limites de la technologie. D'autre part, on sait très bien faire fonctionner un transistor à effet de champ avec une seule grille qui contrôle le passage du courant entre les deux électrodes dites source et drain ; par contre, on sait moins bien contrôler le fonctionnement d'un transistor bi-grilles, et on ne sait plus contrôler le fonctionnement d'un transistor à plus que deux grilles. Or, il est intéressant dans certains cas d'avoir plus que deux entrées : il fallait donc rechercher une structure d'opérateur telle qu'elle n'utilise pas de porte ET, de façon à ne pas avoir de transistors bi-grilles, et que cependant il soit possible d'avoir un grand nombre d'entrées, supérieur à 2.

A titre d'exemple et de comparaison, les diviseurs de fréquences selon l'art connu fonctionnent actuellement à des fréquences de fonctionnement maximum allant de 4,1 GHz, pour des longueurs de grille des transistors à effet de champ de 1,2 micron, jusqu'à une fréquence de 5,7 GHz pour des longueurs de grille de 0,8 micron. Passer au-delà de ces fréquences nécessitait donc un changement dans le dessin et la conception de la bascule.

Parmi les structures de bascules possibles, et réalisables en technologie à effet de champ interfacé, (BFL), un opérateur complexe de type OU-NON/OU est particulièrement intéressant. C'est celui qui est représenté par la figure 5.

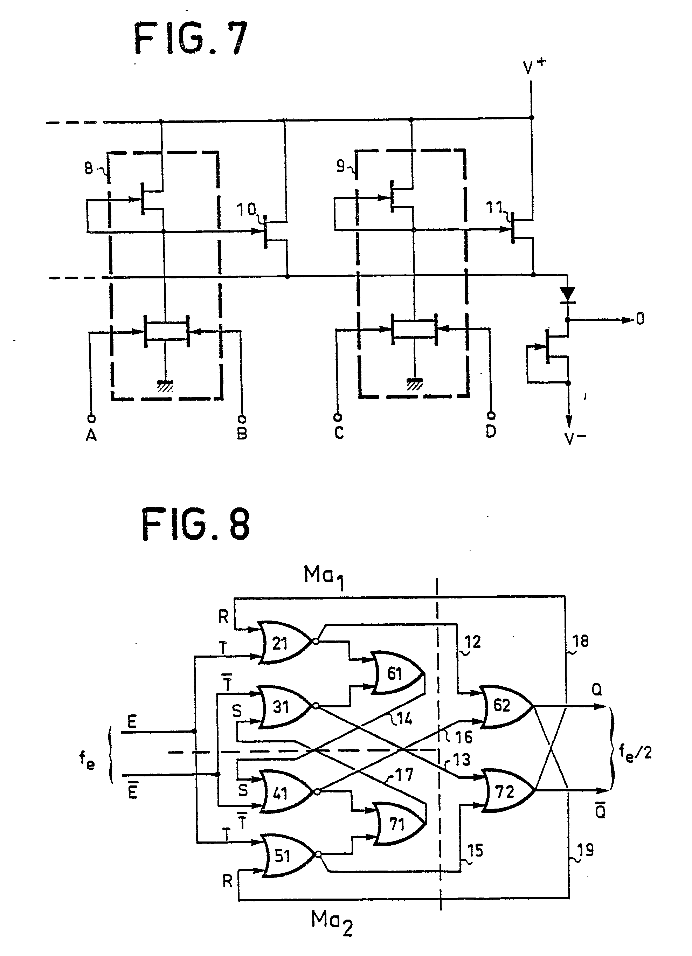

Cette bascule de type RST est constituée par quatre opérateurs OU-NON, 2, 3, 4, et 5 et par deux opérateurs OU, 6 et 7. Le signal d'entrée T est appliqué aux deux opérateurs OU-NON 2 et 5, qui reçoivent également et respectivement les signaux R et S. Les deux opérateurs OU-NON 3 et 4 reçoivent les signaux de sortie Q et $\bar{Q}$ rebouclés à partir des opérateurs OU 6 et 7. L'application de cette bascule RST utilisant des opérateurs OU-NON et des opérateurs OU est illustrée en figure 6 qui représente une bascule de type RSTT̄. Un rapprochement doit être fait entre la bascule de la figure 2 et celle de la figure 6.

En effet, alors que la bascule de la figure 2 utilisait deux opérateurs complexes maîtres $Ma_1$ et $Ma_2$ et deux opérateurs complexes esclaves $Esc_1$ et $Esc_2$, on retrouve la même configuration maître-esclave dans la bascule de la figure 6, divisée sur le dessin par deux traits en pointillé qui délimitent les opérateurs maître et esclave. L'opérateur maître $Ma_1$ est constitué des opérateurs élémentaires 21, 31 et 61, l'opérateur maître $Ma_2$ est constitué des opérateurs élémentaires 41, 51 et 71. L'opérateur complexe esclave $Esc_1$ est constitué des opérateurs élémentaires 22, 32 et 62, et l'opérateur complexe esclave $Esc_2$ est constitué des opérateurs élémentaires 42, 52 et 72.

Ces opérateurs sont rebouclés entre eux, ils reçoivent des signaux complémentaires T et $\bar{T}$, et délivrent des signaux de sorties Q et $\bar{Q}$ de façon tout à fait comparable à la bascule de la figure 2.

Cependant, la bascule de la figure 6 est composée des opérateurs OU-NON et OU, selon le schéma logique de la figure 5, et cette configuration permet d'utiliser, dans l'intégration réelle sur une pastille semiconductrice, des transistors à une seule grille, comme le montre le schéma électrique de la figure 7.

Sur ce schéma électrique, on retrouve deux opérateurs OU-NON, représentés par les trois transistors encadrés par un pointillé et repérés 8 et 9, et un opérateur OU constitué par l'ensemble de deux transistors 10 et 11. Le premier intérêt de ce genre de structure est que les transistors utilisés dans les opérateurs OU-NON, pour les entrées repérées A, B, C et D sont des transistors mono-grille, c'est-à-dire qu'il sera possible de réaliser des grilles de dimensions beaucoup plus petites correspondant à de plus grandes fréquences. Le second intérêt est que les fonctions OU-NON et OU sont séparées, et cet avantage sera montré ultérieurement.

Un diviseur par 2 constitué par la bascule selon la figure 6 permet de gagner 15 % en vitesse de fonctionnement par rapport au diviseur utilisant les opérateurs ET/OU-NON pour une puissance dissipée égale, c'est-à-dire 20 milliwatts par opérateur. La fréquence de fonctionnement passe ainsi à 4,7 GHz, en comparaison avec 4,1 GHz qui correspondait à un diviseur par 2 selon la figure 2.

Cependant, on peut observer que la bascule de la figure 6 comporte quatre étages d'opérateurs élémentaires, c'est-à-dire un premier étage d'opérateurs OU-NON 21, 31, 41, 51, un second étage d'opérateurs OU 61, 71, un troisième étage d'opérateurs OU-NON 22, 32, 42, 52, et un quatrième étage d'opérateurs OU 62, 72. Ce qui signifie que le temps de transition à travers la bascule est égal à la somme des temps de transition à travers chacun des quatre étages.

Il est possible d'améliorer le temps de transition total de la bascule, c'est-à-dire sa fréquence de fonctionnement, si on peut simplifier cette bascule pour diminuer le nombre d'étages. C'est l'objet de l'invention qui par simplification de la bascule de la figure 6, aboutit à une bascule ne comptant plus que trois étages soit, si l'on considère que les temps de transitions sont équivalents pour chaque étage, un gain de 30 % en fréquence.

En effet, on peut considérer un certain nombre de redondances qui permettent de supprimer des opérateurs élémentaires dans la bascule complémentée de la figure 6. L'opérateur OU 61 du second étage délivre sur sa sortie un signal qui est appliqué simultanément aux opérateurs OU-NON 41 du premier étage et 22 du troisième étage : il suffira d'en conserver un seul sur les deux. De la même façon, l'opérateur OU 71 du second étage délivre sur sa sortie un signal appliqué simultanément sur les opérateurs OU-NON 31 du premier étage et 52 du troisième étage : la même simplification sera à effectuer. Par ailleurs, l'opérateur OU 62 du quatrième étage délivre sur sa sortie un signal appliqué en parallèle sur l'opérateur OU-NON 51 du premier étage et sur l'opérateur OU-NON 42 du troisième étage. Enfin l'opérateur OU 72 du quatrième étage délivre simultanément un signal sur l'opérateur OU-NON 21 du premier étage et sur l'opérateur OU-NON 32 du troisième étage.

On voit donc que les quatre opérateurs OU, 61, 62, 71 et 72 délivrent, chacun, des signaux à deux opérateurs OU-NON identiques du premier et du troisième étages. Il y a donc redondance entre le premier et le troisième étage, il est possible de supprimer le troisième étage pour compacter la bascule : c'est ce qui est montré en figure 8.

Afin de faciliter la comparaison entre la figure 8 et la figure 6, les mêmes indices de repère sont conservés lorsqu'ils désignent les mêmes opérateurs élémentaires.

Puisque les opérateurs élémentaires OU-NON du troisième étage sur la figure 6 ont tous des fonctions parallèles à celles des opérateurs élémentaires du premier étage, les opérateurs du troisième étage sont supprimés, ce qui permet de gagner sur le temps de propagation global du circuit.

Le diviseur par 2 selon l'invention apparaît donc être essentiellement constitué par deux opérateurs complexes $Ma_1$ et $Ma_2$, qui commandent deux opérateurs élémentaires OU 62 et 72. Les opérateurs complexes $Ma_1$ et $Ma_2$ sont départagés sur la figure 8 par deux traits pointillés et leur appellation de $Ma_1$ et $Ma_2$ est conservée par analogie avec la figure 6 puisque ces opérateurs complexes sont constitués des mêmes opérateurs complémentaires. De même, les deux opérateurs OU de sortie sont ceux qui constituent le quatrième étage du diviseur par 2 de la figure 6.

Chacun des deux opérateurs complexes $Ma_1$ et $Ma_2$ est constitué par deux opérateurs OU-NON (21 + 31) dont les deux sorties commandent un opérateur OU (61). Parallèlement, la sortie 12 du premier opérateur OU-NON (21) du premier étage commande une entrée du premier opérateur OU (62) du troisième étage, et la sortie 13 du second opérateur OU-NON (31) du premier étage commande une entrée du second opérateur OU (72) du troisième étage.

La sortie 14 du premier opérateur OU (61) du second étage est rebouclée sur une entrée du troisième opérateur OU-NON (41) du premier étage.

Le schéma d'interconnexion est symétrique pour le second opérateur complexe $Ma_2$ constitué des opérateurs 41, 51, 71.

La sortie 18 de l'opérateur OU (72) du troisième étage est rebouclée sur une entrée du premier opérateur OU-NON (21) du premier étage, et la sortie 19 de l'opérateur OU (62) du troisième étage est rebouclée sur une entrée du quatrième opérateur OU-NON (51) du premier étage.

Les opérateurs complexes $Ma_1$ et $Ma_2$ constituent le premier et le second étage du diviseur par 2 selon l'invention. Les sorties des opérateurs OU 62 et 72 délivrent des signaux Q et $\bar{Q}$, complémentaires, dont la fréquence est la moitié de la fréquence d'entrée sur les entrées complémentaires E et $\bar{E}$.

Les avantages d'une telle structure de diviseur par 2 sont multiples :
— simplification du circuit, car il n'y a plus que 24 transistors monogrille au lieu de 36 transistors,
— réduction de l'entrance du dispositif,
— réduction de la sortance du dispositif avec augmentation des performances en vitesse,
— réduction de la consommation liée à la suppression de quatre étages inverseurs.

Ainsi, à titre d'exemple, la fréquence maximale du diviseur de fréquences selon l'invention est de 6,25 GHz pour une puissance par porte équivalente de 15 milliwatts, ce qui correspond déjà à un accroissement de 33 % par rapport au diviseur selon l'art connu. Mais par optimisation totale des paramètres du circuit, et en particulier du dimensionnement des transistors, avec des grilles de longueur 0,3 micron, la performance extrême du diviseur selon l'invention atteint 10 GHz : dans ce cas, la puissance équivalente par porte est de 53 milliwatts.

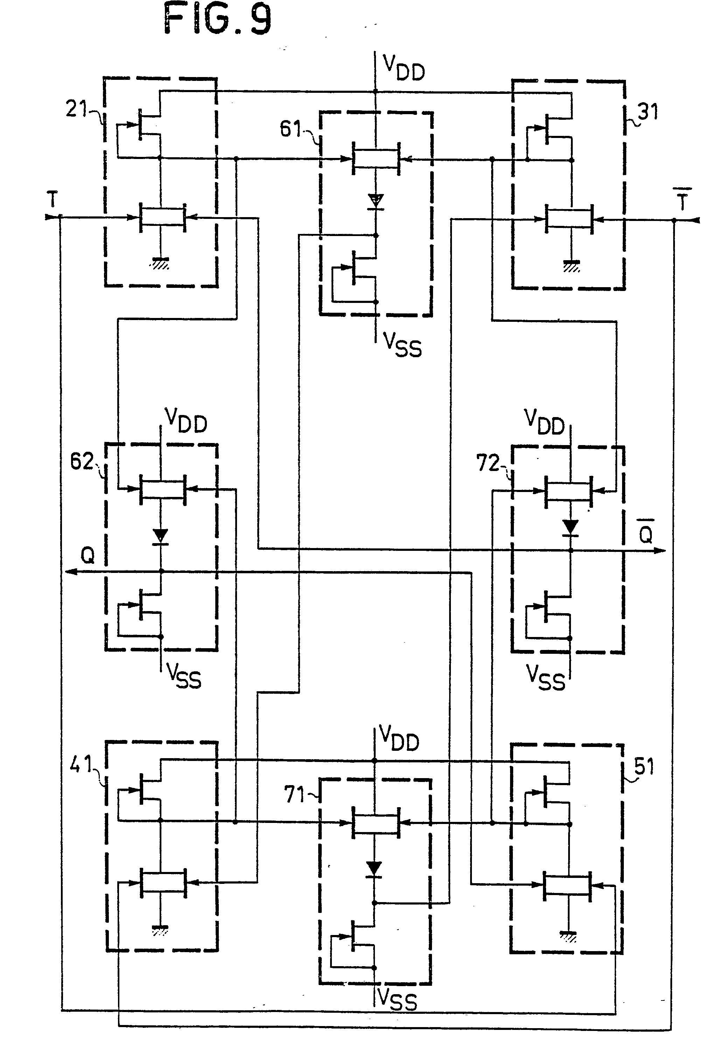

La figure 9 représente le schéma électrique de la bascule selon l'invention et les ensembles de composants qui constituent des opérateurs élémentaires sont entourés d'un trait pointillé pour faciliter leur identification. Les opérateurs OU-NON 21, 31, 41, et 51 sont dans les quatre coins de la figure et ils constituent le premier étage du diviseur par 2. Les opérateurs OU 61 et 71 sont disposés sur la diagonale verticale de la figure et ils constituent le second étage du diviseur par 2. Les opérateurs OU 62 et 72 sont disposés sur la diagonale horizontale de la figure et ils constituent le troisième étage du diviseur par 2. On voit que, comme sur la figure 8, les entrées qui délivrent des signaux complémentaires T et $\bar{T}$ sont adressées aux quatre opérateurs du premier étage 21, 31, 41 et 51 et que les sorties Q et $\bar{Q}$, qui sont à une fréquence moitié de la fréquence d'entrée des signaux T et T, sont délivrées sur les sorties des opérateurs 62 et 72. Les opérateurs des premier, second et troisième étages sont rebouclés entre eux conformément à la figure 8.

La bascule de type RST$\bar{T}$ selon l'invention a été mise au point pour la réalisation d'un diviseur de fréquence par 2 caractérisé par une très large bande de fonctionnement puisque son fonctionnement a été contrôlé entre le continu et la bande X c'est-à-dire 10 GHz. Ce circuit trouve son application dans les interfaces entre les très hautes fréquences qui se mesurent en GHz et les systèmes de contrôle ou d'analyse fonctionnant à de plus basses fréquences qui se mesurent en MHz. Ce résultat a été obtenu par l'abandon de la structure de bascule de type ET/OU-NON généralement utilisée au profit d'une structure OU-NON/OU qui permet une simplification technologique et par voie de conséquence un gain en performance.

Il est évident pour l'homme de l'art que la réalisation de diviseurs de fréquences d'ordre supérieur à 2 s'obtient par une suite de diviseurs de fréquences par 2 selon l'invention, et que les données technologiques qui ont été citées telles que la technologie en logique à transistors à effet de champ interfacée, ou la longueur des grilles utilisées ne sauraient en aucun cas restreindre la portée de l'invention qui s'applique à une structure de bascule utilisant des opérateurs OU-NON/OU, et peut être réalisée dans d'autres technologies que celles qui ont été citées à titre d'exemple. La présente invention de bascule et de diviseur de fréquences par 2 est précisée par les revendications suivantes.

## Revendications

1. Bascule logique, fonctionnant du continu à 10 GHz, comportant un premier étage (étage d'entrée) constitué par quatre opérateurs logiques OU-NON (21, 31, 41, 51) en parallèle, et un second étage (étage intermédiaire) constitué par deux opérateurs logiques OU (61, 71) en parallèle, le premier étage comportant deux entrées (E, $\bar{E}$) sur lesquelles sont adressés deux signaux complémentaires (T, $\bar{T}$) à fréquence $f_e$, l'une (E) des deux entrées étant reliée à une entrée de chacun des premier (21) et quatrième (51) opérateurs logiques OU-NON, tandis que l'autre ($\bar{E}$) entrée est reliée à une entrée de chacun des deuxième (31) et troisième (41) opérateurs logiques OU-NON,

le signal de sortie du premier opérateur OU (61) du second étage, qui reçoit sur ses entrées les signaux du premier et du second opérateurs OU-NON (21, 31) du premier étage, est rebouclé sur une entrée du troisième opérateur OU-NON (41) du premier étage,

le signal de sortie du second opérateur OU (71) du second étage, qui reçoit sur ses entrées les signaux du troisième et du quatrième opérateurs OU-NON (41, 51) du premier étage, est rebouclé sur une entrée du second opérateur OU-NON (31) du premier étage,

cette bascule logique étant caractérisée en ce qu'elle comprend en outre un troisième étage (étage de sortie) constitué par deux opérateurs logiques OU (62, 72) en parallèle,

le signal de sortie de chacun des quatre opérateurs du premier étage (21, 31, 41, 51) est adressé à un opérateur OU du second étage (61, 71) et à un opérateur OU du troisième étage (62, 72),

le signal de sortie du premier opérateur OU (62) du troisième étage, qui reçoit sur ses entrées les signaux du premier et du troisième opérateurs OU-NON (21, 41) du premier étage, est rebouclé sur une entrée du quatrième opérateur OU-NON (51) du premier étage,

le signal de sortie du second opérateur OU (72) du troisième étage, qui reçoit sur ses entrées les signaux du second et du quatrième opérateur OU-NON (31, 51) du premier étage, est rebouclé sur une entrée du premier opérateur OU-NON (21) du premier étage.

2. Bascule logique selon la revendication 1, caractérisée en ce qu'elle est réalisée en circuit monolithique sur un cristal de matériau semiconducteur, utilisant une technologie de transistors à grille unique.

3. Diviseur de fréquence, fonctionnant dans la gamme 0 à 10 GHz, caractérisé en ce qu'il comporte au moins une bascule logique selon l'une quelconque des revendications 1 ou 2.

## Claims

1. Logical bistable circuit functioning from d. c. to 10 GHz, comprising a first stage (input stage) formed by four logic NOR operators (21, 31, 41, 51) in parallel, and a second stage (intermediate stage) formed by two logic OR operators (61, 71) in parallel, the first stage comprising two inputs (E, $\bar{E}$) to which are addressed two complementary signals (T, $\bar{T}$) of frequency $f_e$, one (E) of said inputs being connected to an input respectively of the first (21) and the fourth (51) logic NOR operator whilst the other input ($\bar{E}$) is connected to an input respectively of the second (31) and third (41) logic NOR operator,

the output signal of the first OR operator (61) of the second stage, which receives at its inputs the signals of the first and the second NOR operator (21, 31) of the first stage, being fed back to an input of the third NOR operator (41) of the first stage,

the output signal of the second OR operator (71) of the second stage, which receives at its inputs the signals of the third and the fourth NOR operator (41, 51) of the first stage, being fed back to an input of the second NOR operator (31) of the first stage,

this logic bistable circuit being characterized in that it further comprises a third stage (output stage) formed by two logic OR operators (62, 72) in parallel,

the output signal of each of the four operators (21, 31, 41, 51) of the first stage being addressed in parallel to an OR operator of the second stage (61, 71) and to an OR operator of the third stage (62, 72),

the output signal of the first OR operator (62) of the third stage, which at its inputs receives the signals of the first and third NOR operators (21, 41) of the first stage, being fed back to an input of the fourth NOR operator (51) of the first stage,

and the output signal of the second OR operator (72) of the third stage, which receives at its inputs the signals of the second and fourth NOR operators (31, 51) of the first stage, being fed back to an input of the first NOR operator (21) of the first stage.

2. Logic bistable circuit according to claim 1, characterized in that it is formed as monolithic circuit on a semiconductor crystal using single gate transistor technology.

3. Frequency divider operating in the range from 0 to 10 GHz, characterized in that it comprises at least one logic bistable circuit according to any one of claims 1 or 2.

**Patentansprüche**

1. Logische Kippschaltung, die von Gleichstrom bis 10 GHz arbeitet, versehen mit einer ersten Stufe (Eingangsstufe), welche durch vier logische NOR-Operatoren (21, 31, 41, 51) in Parallelschaltung gebildet ist, und mit einer zweiten Stufe (Zwischenstufe), die durch zwei logische OR-Operatoren (61, 71) in Parallelschaltung gebildet ist, wobei die erste Stufe zwei Eingänge (E, Ē) aufweist, an welche zwei komplementäre Signale (T, T̄) der Frequenz $f_e$ angelegt werden, wobei einer (E) dieser zwei Eingänge mit einem Eingang jeweils des ersten (21) und des vierten (51) logischen NOR-Operators verbunden ist, während der andere Eingang (Ē) mit jeweils einem Eingang des zweiten (31) und dritten (41) logischen NOR-Operators verbunden ist,

wobei das Ausgangssignal des ersten OR-Operators (61) der zweiten Stufe, die an ihren Eingängen die Signale des ersten und des zweiten NOR-Operators (21, 31) der ersten Stufe empfängt, auf einen Eingang des dritten NOR-Operators (41) der ersten Stufe rückgeschleift ist,

wobei das Ausgangssignal des zweiten OR-Operators (71) der zweiten Stufe, welche an ihren Eingängen die Signale des dritten uñ des vierten NOR-Operators (41, 51) der ersten Stufe empfängt, auf einen Eingang des zweiten NOR-Operators (31) der ersten Stufe rückgeschleift ist,

wobei diese logische Kippschaltung dadurch gekennzeichnet ist, daß sie ferner eine dritte Stufe (Ausgangsstufe) umfaßt, die aus zwei logischen OR-Operatoren (62, 72) in Parallelschaltung gebildet ist,

wobei das Ausgangssignal jedes der vier Operatoren (21, 31, 41, 51) der ersten Stufe parallel an einen OR-Operator der zweiten Stufe (61, 71) und an einen OR-Operator der dritten Stufe (62, 72) angelegt wird,

wobei ferner das Ausgangssignal des ersten OR-Operators (62) der dritten Stufe, welche an ihren Eingängen die Signale des ersten und des dritten NOR-Operators (21, 41) der ersten Stufe empfängt, auf einen Eingang des vierten NOR-Operators (51) der ersten Stufe rückgeschleift ist,

und wobei das Ausgangssignal des zweiten OR-Operators (72) der dritten Stufe, welche an ihren Eingängen die Signale des zweiten und des vierten NOR-Operators (31, 51) der ersten Stufe empfängt, auf einen Eingang des ersten NOR-Operators (21) der ersten Stufe rückgeschleift ist.

2. Logische Kippschaltung nach Anspruch 1, dadurch gekennzeichnet, daß sie als monolithische Schaltung auf einem Halbleiterkristall unter Anwendung der Technologie der Transistoren mit einzigem Gate ausgebildet ist.

3. Frequenzteiler, der im Bereich 0 bis 10 GHz arbeitet, dadurch gekennzeichnet, daß er wenigstens eine logische Kippschaltung nach einem der Ansprüche 1 und 2 aufweist.

# FIG.1

# FIG. 2

# FIG.3

1

# FIG.4

A  B  D  C  V⁻  V⁺  O

# FIG.5

OU - NON
R
2
OU
6
Q
3
T
4
5
7
Q̄
S

# FIG.6

R  Ma₁  R  Esc₁
T  21  T̄  22
T̄  61  T  32
31  Q  62  Q
E
Ē
T̄  41  T  42
T  71  T̄  72  Q̄
51  Q̄  S  52
S  Ma₂  Esc₂

2

# FIG. 7

# FIG. 8

# FIG.9